# FASCICULE DE BREVET EUROPEEN

(11) **EP 0 428 601 B1**
(45) Date de publication et mention de la délivrance du brevet: **06.10.1993**
(21) Numéro de dépôt: 89909403.1
(22) Date de dépôt: 03.08.1989
(51) Int. Cl.: G01R 31/12, G01R 15/06

(54) **SYSTEME DE MESURE DE DECHARGES PARTIELLES**
ANORDNUNG ZUR MESSUNG VON TEILENTLADUNGEN
SYSTEM FOR MEASURING PARTIAL DISCHARGES

(30) Priorité: 04.08.1988 FR 8810565
(43) Date de publication de la demande: 29.05.1991
(73) Titulaire: GEC ALSTHOM SA, 75116 Paris (FR)
(72) Inventeur: TRIPIER, Jean-Louis, F-94300 Vincennes (FR); BERGOT, Jean-Yves, F-93380 Pierrefitte (FR)
(74) Mandataire: Weinmiller, Jürgen, Dipl.-Ing.
(86) Numéro de dépôt international: FR8900406
(87) Numéro de publication internationale: WO9001704

(56) Documents cités:
- DE-A-36 122 344
- DE-A-37 262 87
- US-A-47 572 63
- Elektrotech. Maschinenbau, vol. 95, Nr. 12, December 1978, A.L. Ove et al.: "Ein Teilentladungsmessplatz für Grosstransformatoren", pages 561-564
- TM/Technisches Messen, vol. 55, Nr. 1, 1988 (Munich/DE), F.H. Kreuger et al.: "Simultane Erfassung und Verarbeitung von Teilentladungs-Kenngrössen zur Beurteilung elektrischer Isolierungen", pages 17-22
- International Conference on Large High Voltage Electric Systems, Proceedings of the 29th session, vol. 1, Communication 15-12, 1-9 September 1982 (Paris/France), F. Viale et al.: "Study of a correlation between energy of partial discharges and degradation of paper-oil insulation", pages 1-9

## Description

La présente invention a pour objet un système de mesure de décharges partielles.

Les décharges partielles se produisent dans les équipements utilisés dans les installations à haute tension des réseaux de transport et de distribution d'énergie électrique, par exemple. Dans une chaîne diéletrique soumise à la haute tension, un élément est le siège d'un claquage et l'énergie correspondant à la charge capacitive de cet élément est dissipée sous la forme d'une oscillation à fréquence élevée. Les autres éléments de la chaîne conservent leur intégrité, de sorte que la décharge partielle n'entraîne pas de claquage de l'ensemble.

L'étude des décharges partielles permet d'évaluer la qualité d'un équipement et fournit des indications utiles lorsqu'il s'agit de l'améliorer. Il est donc important de pouvoir effectuer des mesures relatives aux décharges partielles. Des appareils de mesure spécifiques ont été développés à cette fin. On mentionnera par exemple le système de mesure 9100 de la firme "Tettex AG". dont une description est donnée dans la publication "Tettex Instruments - Information", n°21, d'Avril 1987. Un tel appareillage effectue des mesures sur les impulsions de courant et de tension issues des décharges partielles et affiche les valeurs maximales observées. Des impulsions individuelles peuvent également être observées à l'aide d'un oscilloscope. Par ailleurs, la répétition des décharges partielles est également significative. Dans la communication n° 15-12. "Recherche d'une corrélation entre l'énergie des décharges partielles et la dégradation d'une isolation papier/huile", de F. Viale et al, faite à la Conférence Internationale des Grands Réseaux Electriques", Session de 1982, on mentionne une intégration de l'énergie des décharges partielles pendant une période donnée.

Dans l'article "Simultane Erfassung und Verarbeitung von Teilentladungs-Kenngrössen zur Beurteilung elektrischer Isolierungen" de F.H. Kreuger et al, publié dans "Teschnisches Messen" Vol. 55, Nr. 1, 1988, pages 17 à 22, il est par ailleurs décrit un système dans lequel un microcalculateur saisit les valeurs numériques différentes relatives à chaque instant à une même décharge partielle. Il y est traité des mesures à prendre pour réduire le volume d'information à enregistrer et on y évoque même, sans proposer de solution, la conservation du régime temporel des signaux enregistrés.

Le document de brevet DE-A-36 12 234 décrit un système du même type.

Le brevet US-A-4 757 263 décrit un appareillage de surveillance de différentes grandeurs électriques dans une même installation, mais ces grandeurs ont plutôt un caractère continu, à la différence des signaux engendrés par les décharges partielles qui sont impulsifs et imprévisibles.

Or l'observation de décharges partielles en plusieurs points pose le problème d'enregistrer de façon continue ou quasi-continue une énorme quantité d'information, à moins de sélectionner arbitrairement des périodes d'observation et de s'exposer à manquer des observations utiles, ou encore de traiter les résultats d'observation ce qui est coûteux en moyens de traitement. Aucune de ces solutions n'est satisfaisante. En pratique cela empêche l'expérimentateur d'avoir une vision complète de l'activité des décharges, et laisse à son expérience ou son habileté la sélection de décharges particulièrement significatives. Il est pourtant de nombreux cas où il serait souhaitable d'obtenir des informations plus complètes sur les décharges partielles, notamment dans les études portant sur la corrélation entre les décharges et les détériorations des équipements qui en sont le siège. L'énergie d'une décharge partielle est en effet une mesure de sa nocivité, mais encore faut-il savoir de quel type de décharge il s'agit, c'est-à-dire où elle s'est produite. Cela peut se déduire d'observations faites simultanément en plusieurs points, par exemple.

La présente invention a précisément pour objet un système de mesure de décharges partielles répondant à ce besoin.

Le système de mesure de décharges partielles de la présente invention comprend des premiers et des deuxièmes dispositifs d'acquisition comprenant chacun une entrée de signal, un dispositif de mise en forme de signal fournissant une valeur de signal, un multiplexeur permettant de fournir, successivement sur une voie commune à destination d'un système de mémorisation et de traitement de signaux, des valeurs de signaux fournies par les différents dispositifs d'acquisition. Il se caractérise en ce que lesdits premiers dispositifs d'acquisition reçoivent des signaux de décharge partielle différents issus de différents points d'une installation et en ce qu'il est prévu un dispositif de déclenchement d'acquisition répondant à l'existence d'un signal de décharge partielle fourni par un comparateur lorsque le niveau d'entrée d'un dispositif d'acquisition au moins, dépasse un seuil défini et fournissant un signal de commande d'acquisition, ledit système de mémorisation et de traitement de signaux répondant au signal de commande d'acquisition et effectuant alors un cycle d'acquisition au cours duquel il mémorise les valeurs de signaux fournies par les différents dispositifs d'acquisition, au travers du multiplexeur.

Un tel système permet l'enregistrement asynchrone de groupes de valeurs de signaux correspondant chacun à l'une de décharges partielles successives. Il importe cependant de localiser dans le temps les décharges partielles.

Selon une autre caractéristique de l'invention, l'un desdits deuxièmes dispositifs d'acquisition dit dispositif d'acquisition de tension fournit la mesure instantanée de la tension alternative du réseau de distribution.

Cela permet de localiser un groupe de valeurs de signaux par rapport à la demi-période de la tension alternative.

Selon une autre caractéristique de l'invention, ledit dispositif d'acquisition de tension comprend des moyens conditionnant la fourniture de la mesure de la tension alternative du réseau de distribution par la présence dudit signal de commande d'acquisition.

Selon encore une autre caractéristique de l'invention, ledit dispositif de déclenchement d'acquisition de tension comprend des moyens sensibles à l'apparition d'une valeur de tension maximale sur l'entrée dudit dispositif d'acquisition de tension et fournissant alors un signal de commande d'acquisition additionnel, ledit système de mémorisation et de traitement de signaux répondant au signal de commande d'acquisition additionnel et effectuant alors un cycle d'acquisition.

Cela permettra par conséquent de repèrer les groupes de valeurs enregistrés par rapport aux demi-périodes de la tension du réseau.

Dans une forme de réalisation, le système de mémorisation et de traitement de signaux sera un calculateur du commerce convenablement programmé. Les valeurs de signaux seront converties sous forme numérique, de préférence après le multiplexage.

Les différents objets, caractéristiques et avantages de la présente invention seront détaillés dans la description qui va suivre, donnée à titre d'exemple non limitatif, en se reportant aux figures annexées qui représentent :
- la figure 1, le schéma de principe des circuits permettant d'obtenir des signaux à mesurer par le système de l'invention,
- la figure 2, Le schéma de raccordement du système de l'invention, dans le cas de mesures portant sur un transformateur,
- la figure 3, le schéma synoptique d'un dispositif d'acquisition de décharges partielles,
- la figure 4, le schéma synoptique d'un dispositif d'acquisition de tension alternative d'alimentation,
- la figure 5, le schéma d'un dispositif de commande d'acquisition,
- la figure 6, le diagramme général d'un système de mesure de décharges partielles conforme à la présente invention.

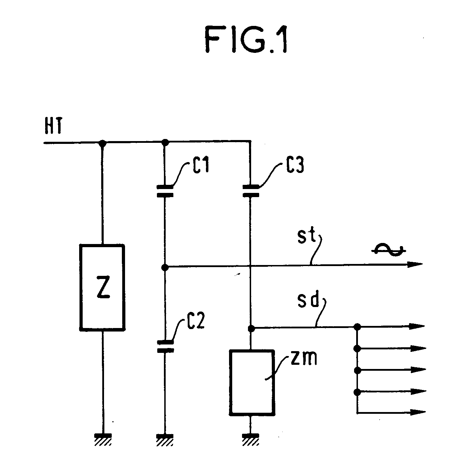

On se reportera d'abord à la figure 1 qui représente un équipement en essais Z connecté entre une ligne d'alimentation en haute tension HT et la masse, ainsi que, pour obtenir des signaux de mesure de tension, un diviseur de tension capacitif composé des condensateurs C1 et C2, au point commun desquels est disponible, sur la sortie st, un signal de tension sous la forme d'une tension alternative dont la valeur est une fraction de la haute tension, et que, pour obtenir des signaux de mesure de décharges partielles, un diviseur de tension comprenant, de manière connue, un condensateur C3 et une impédance zm au point commun desquels est disponible, sur la sortie sd, à l'occasion de chaque décharge partielle se produisant dans l'équipement Z, un signal impulsionnel de décharge partielle ayant une forme générale d'oscillation sinusoïdale amortie.

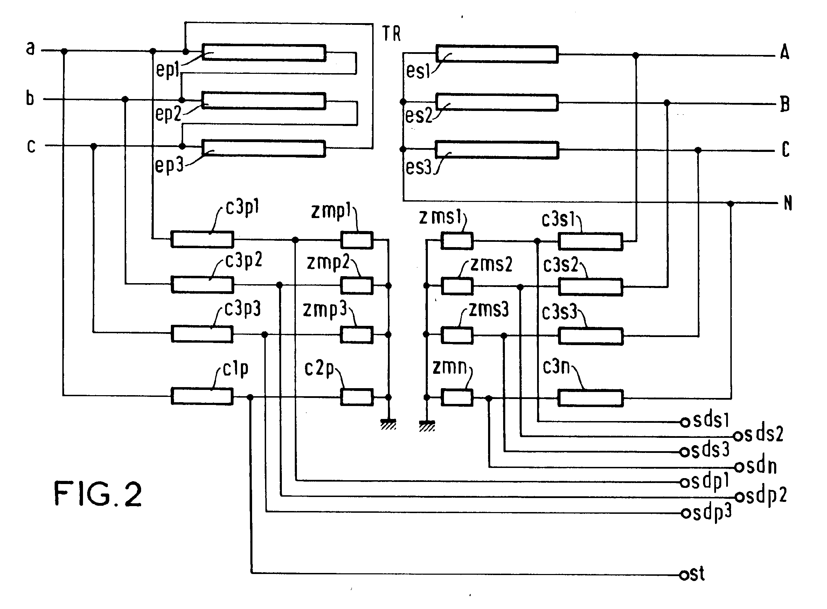

La figure 2 représente, en tant qu'équipement en essais, un transformateur triphasé TR, avec ses trois enroulements primaires en triangle ep1, ep2, ep3, connectés aux trois fils d'une ligne à basse tension a, b, c, et ses trois enroulements secondaires en étoile es1, es2, es3 connectés à quatre fils d'une ligne de distribution A, B, C,N.

Pour la mesure, on retrouve, selon le montage de la figure 1, des condensateurs C3p1, C3p2, C3p3, C3s1, c3s2, c3s3 et c3n, jouant le rôle du condensateur C3 et des impédances zmp1...,zms3 et zmn, jouant le rôle de l'impédance zm, vis-à-vis de sorties de signaux de décharges partielles sdp1 à sds3 et sdn. De même les condensateurs c1p et c2p jouent le rôle des condensateurs C1, C2 , vis-à-vis d'une sortie de signal de tension.

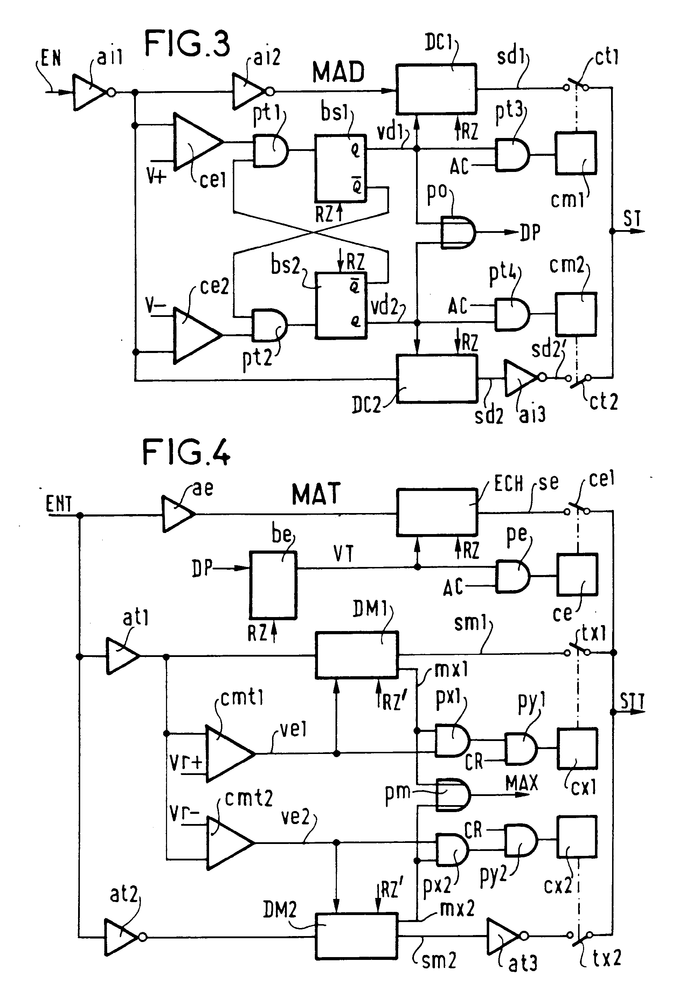

Le dispositif d'acquisition de décharges partielles MAD de la figure 3 traite l'un quelconque des signaux de décharge partielle et le met en forme ; par ailleurs, il contribue à l'élaboration d'un signal de commande d'acquisition. Ce dispositif , à partir d'une entrée EN, à laquelle est par exemple connectée la sortie sds1 de la figure 2, comprend un premier amplificateur inverseur ai1, opérant une adaptation de niveau. Le signal résultant, à la sortie de l'amplificateur ai1, est appliqué à une entrée de deux comparateurs, ce1 et ce2 recevant par ailleurs deux tensions de référence V+ et V-. Si le signal de sortie de l'amplificateur ai1 dépasse la tension V+, le comparateur ce1 fournit un signal qui traverse la porte pt1 et change de position la bascule bs1. Celle-ci fournit alors un signal vd1 qui active un détecteur de crête DC1. En même temps, un signal complémentaire vr1 bloque la porte pt2. Dès cet instant le detecteur de crête DC1, qui reçoit le signal de sortie de l'amplificateur ai1 à travers un amplificateur inverseur additionnel à gain unité ai2, maintient sur sa sortie sd1 un niveau de signal qui correspond au niveau positif maximal atteint par le signal d'entrée. En même temps, par une porte OU po, le dispositif fournit un signal DP indiquant la détection d'une décharge partielle. La lecture du niveau atteint par la décharge partielle s'effectue par la fourniture d'un signal AC. Conjointement avec le signal vd1, le signal AC débloque la porte pt3 et provoque le fonctionnement d'un commutateur cm1 fermant un contact ct1, de sorte que le niveau de signal présent sur la sortie sd1 du détecteur de crête DC1 est fourni sur la sortie ST du dispositif.

Si le signal d'entrée est négatif et dépasse le seuil V-, par le comparateur ce2, la porte pt2, la bascule bs2, la porte pt4 et le commutateur cm2 fermant le contact ct2, le fonctionnement est le même, le détecteurde crête DC2 recevant directement le signal de sortie de l 'amplificateur ai1 et traitant par conséquent un signal de même polarité que le détecteur de crête DC1, tandis que l'amplificateur auxiliaire ai3 à gain unité inverse le signal de sortie sd2 du détecteur de crête DC2 pour fournir un signal sd2' de la polarité du signal d'entrée sur la sortie ST. Le signal DP est fourni par la porte po comme précédemment.

Ainsi, le dispositif MAD de la figure 3, à l'apparition d'un signal de décharge partielle, sélectionne la polarité de la première alternance de ce signal et, pour cette polarité, retient la valeur de tension crête atteinte qui est préparée comme valeur de signal, tandis qu'un signal de présence de décharge partielle est fourni pour demander une acquisition. L'acquisition permet de lire sur la sortie ST la valeur de signal. Ensuite, un signal RZ remet au repos la bascule bs1 ou bs2 et le détecteur de crête DC1 ou DC2 et le dispositif retourne dans son état initial.

Le dispositif d'acquisition de tension alternative d'alimentation MAT de la figure 4, met en forme les signaux de tension provenant par exemple de la sortie st du montage de la figure 2 et déclenche l'acquisition lorsque la tension passe par un maximum positif ou négatif. Ces deux aspects sont en fait traités séparément.

La mise en forme du signal de tension est réalisée principalement à l'aide d'un circuit d'échantillonnage ECH qui reçoit le signal fourni à l'entrée ENT du dispositif à travers un amplificateur abaisseur d'impédance à gain unité ae. Le signal DP fourni par l'un quelconque des dispositifs conformes à la figure 3 lorsqu'une décharge partielle est signalée change de position une bascule be qui valide le circuit d'échantillonnage ECH. Celui-ci enregistre la valeur de la tension qui lui est fournie à cet instant par l'amplificateur ae et maintient la valeur enregistrée sur sa sortie se. Au moment de l'acquisition, le signal de sortie de la bascule be permet au signal AC de franchir la porte pe et de provoquer le fonctionnement du commutateur ce qui ferme alors son contact ce1, founissant la valeur de tension échantillonnée sur la sortie STT.

Ainsi, cette partie VT du dispositif de la figure 4 fonctionne en complément de dispositifs MAD tels que celui de la figure 3 et fournit, à l'occasion de chaque décharge partielle, une valeur de la tension alternative relevée sur l'un des conducteurs de la ligne à haute tension alimentant l'équipement en essais ; cela permettra de localiser la décharge partielle à l'intérieur d'une demi-période de cette tension alternative.

L'invention prévoit encore de détecter et d'enregistrer les maxima positifs et négatifs de la tension alternative, afin de permettre une localisation dans le temps des décharges partielles par rapport aux demi-périodes de la tension alternative.

A cette fin, dans le dispositif MAT de la figure 4, la tension d'entrée est appliquée, par l'intermédiaire d'un amplificateur abaisseur d'impédance de gain unité at1, à un comparateur cmt1 recevant par ailleurs une tension Vr+. Cette tension est relativement faible et permet d'orienter les alternances positives et négatives de la tension alternative vers les circuits destinés à les traiter. Le comparateur cmt1, lorque cette tension est dépassée, fournit un signal ve1 qui valide le dispositif de détection de maximum DM1. Un dispositif de ce type est vendu par "Precision Monolithics, Inc." sous la référence PKD-O1. Ce dispositif surveille le signal qui lui est fourni par l'amplificateur at1, avec les constantes de temps appropriées, et fournit un signal mx1 lorsque l'amplitude de ce signal commence à décroître. A travers un porte pm, ce signal mx1 fournit un signal MAX indiquant un maximum (positif, dans ce cas) de la tension alternative évaluée et demandant une acquisition. De plus, le dispositif DM1 échantillonne le signal alternatif et maintient sur sa sortie sm1 l'échantillon obtenu au moment où il fourni le signal mx1. Le signal mx1, par la porte px1, valide la porte py1. Lors de l'acquisition, un signal CR est fourni au dispositif de la figure 4 et, par la porte py1, il actionne le commutateur cx1 qui ferme le contact tx1. La valeur maximale positive de la tension alternative est ainsi transférée sur la sortie STT.

La tension d'entrée reproduite à la sortie de l'amplificateur at1 est également appliquée à un comparateur cmt2 décelant le franchissement d'un seuil Vr- et fournissant en conséquence un signal ve2 validant le dispositif DM2 identique au dispositif DM1. Ce dispositif DM2 reçoit la tension d'entrée par l'intermédiaire d'un amplificateur inverseur de gain unité at2. Son fonctionnement est ainsi le même que celui du dispositif DM1. Il fournit ainsi un signal mx2 lorsque la tension d'entrée passe par un maximum négatif et la porte pm fournit alors le signal de demande d'acquisition MAX. La valeur échantillonnée maintenue sur la sortie sm2 du dispositif DM2 est inversée par l'amplificateur inverseur at3. Lors de l'acquisition, la porte px2 étant validée par les signaux ve2 et max2 valide elle-même la porte py2 qui transmet le signal CR au commutateur CX2 lequel ferme le contact tx2, et la valeur maximale négative de la tension d'entrée du dispositif de la figure 4 est transmise sur sa sortie STT.

Le dispositif MAT de la figure 4 provoque ainsi une acquisition de tension maximale à chaque demi-période de la tension d'alimentation. Le comptage de ces demi-périodes permettra de suivre le déroulement du temps jusqu'à l'apparition d'une acquisition de décharge partielle, pour localiser cette décharge partielle dans une demi-période définie. La localisation à l'intérieur de la demi-période résultera, on le rappelle, de la valeur de tension issue du dispositif d'échantillonnage ECH, comparée aux valeurs de tensions maximales voisines.

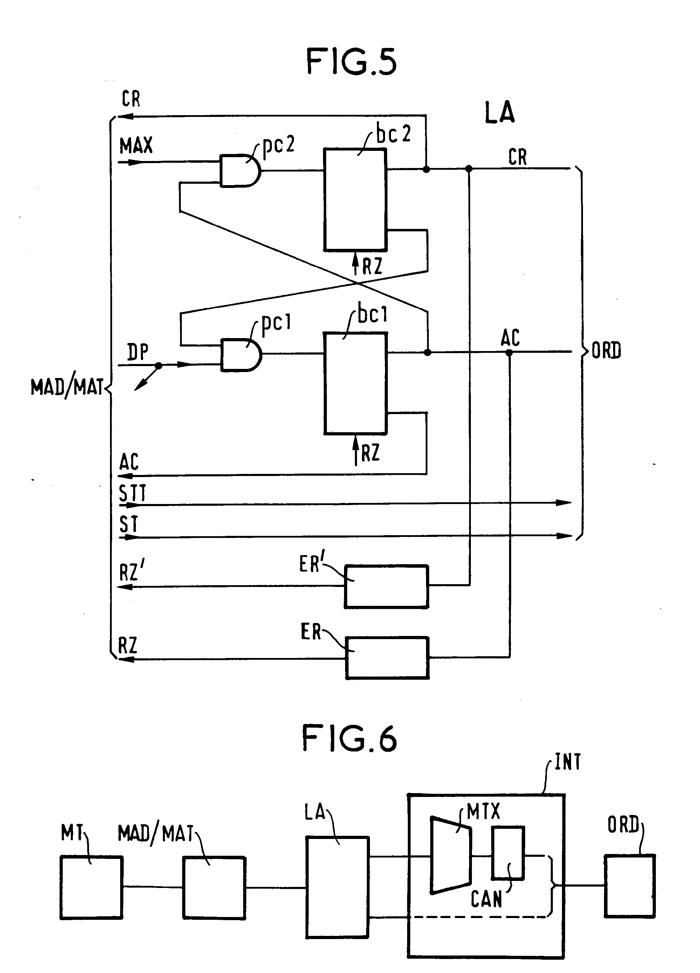

Le dispositif logique de commande d'acquisition LA de la figure 5 sert d'interface entre des dispositifs MAD et MAT conformes aux figures 3 et 4 et un ordinateur à usage général convenablement programmé ORD. Si la bascule bc2 est bien au repos, un signal DP provenant d'un dispositif tel que celui de la figure 3, par la porte pc1, change de position la bascule bc1 qui bloque une porte pc2. La bascule bc1 fournit le signal AC mentionné précédemment par lequel chaque dispositif MAD tel que celui de la figure 3 fournit sur sa sortie ST un signal de décharge partielle correspondant à l'amplitude crête de la première alternance du signal impulsionnel causé par la décharge partielle, tandis que le dipositif MAT de la figure 4 fournit la valeur de la tension alternative à cet instant, maintenue par le circuit d'échantillonnage ECH.

Le signal AC est également transmis vers l'ordinateur ORD, pour provoquer l'éxécution d'un cycle d'acquisition grâce auquel les valeurs ainsi présentées sont enregistrées. Ensuite, avec un retard suffisant, fourni par un étage de retard ER, le dispositif LA fournit le signal RZ, lequel remet la bascule bc1 au repos en même temps que les dispositifs MAD et MAT des figures 3 et 4.

Dans le cas où le signal MAX est fourni par le dispositif de la figure 4, et si, ou dès que, la bascule bc1 est au repos, la porte pc2 conduit et la bascule bc2 change de position, bloquant la porte pc1 et fournissant le signal CR. Un cycle d'acquisition semblable au précédent 5 est accompli. Il se conclut par la fourniture d'un signal RZ' par le circuit à retard ER' du module LA lui-même, qui remet en position initiale la bascule bc2, ainsi que le détecteur de maximum DM1 ou DM2 du dispositif de la figure 4.

La figure 6, enfin, donne un diagramme illustrant un ordinateur ORD, pourvu d'une interface INT contenant un multiplexeur MTX, ainsi qu'un convertisseur analogique-numérique CAN. Les dispositifs d'acquisition MAD et MAT des figures 3 et 4 et la logique de commande d'acquisition LA de la figure 5 sont connectés à l'interface INT. L'interface INT convertit les signaux CR et AC de la logique LA en demandes d'interruption en échange desquelles l'ordinateur ORD adresse les dispositifs MAD/MAT, par l'intermédiaire du multiplexeur MTX et obtient, au moyen du convertisseur CAN interposé, des valeurs numériques correspondant aux grandeurs analogiques disponibles sur les sorties ST et STT. Les signaux CR et AC peuvent d'ailleurs provoquer des cycles d 'acquisition identiques dans lesquels, en reprenant la configuration illustrée à la figure 2, huit voies, traitées par sept dispositifs MAD et un dispositif MAT font l'objet d'un cycle d'enregistrement. Si le cycle d'enregistrement est causé par l'apparition d'une décharge partielle, les huit voies fournissent des informations significatives différentes de zéro. Si le cycle d'enregistement est causé par l 'établissement d'un maximum de la tension alternative d'alimentation, les sept premières voies fournissent des valeurs nulles (puisque le signal AC n'est pas présent) et seule la voie correspondant au dispositif MAT founit un signal non nul (c'est l'amplitude maximale positive ou négative observée de la tension alternative). De tels enregistrements seront ainsi aisément reconnus, pour le comptage des demi-périodes de la tension alternative et la localisation dans le temps des enregistrements concernant les décharges partielles.

## Revendications

1. Système de mesure de décharges partielles comprenant des premiers (MAD) et des deuxièmes (MAT) dispositifs d'acquisition incluant chacun une entrée de signal (EN, ENT) et un dispositif de mise en forme de signal (DC1, DC2, DM1, DM2) fournissant une valeur de signal, un multiplexeur (MTX) permettant de fournir successivement sur une voie commune à destination d'un système de mémorisation et de traitement de signaux des valeurs de signaux fournis par les différents dispositifs d'acquisition, caractérisé en ce que lesdits premiers dispositifs d'acquisition (MAD) reçoivent des signaux de décharge partielle différents issus de différents points d'une installation et en ce qu'il est prévu un dispositif de déclenchement d'acquisition (LA) répondant à l'existence d'un signal de décharge partielle (vd1, vd2) fourni par un comparateur (ce1, ce2) lorsque le niveau d'entrée d'un de ces derniers dispositifs d'acquisition au moins, dépasse un seuil défini (V+, V-) et fournissant un signal de commande d'acquisition (AC) ledit système de mémorisation et de traitement de signaux (ORD) répondant au signal de commande d'acquisition et effectuant alors un cycle d'acquisition au cours duquel il mémorise les valeurs de signaux fournies par les différents dispositifs d'acquisition, au travers du multiplexeur.

2. Système de mesure de décharges partielles conforme à la revendication 1, caractérisé en ce que l'un desdits deuxiemes dispositifs d'acquisition (MAT) dit dispositif d'acquisition de tension fournit la mesure instantanée de la tension alternative du réseau de distribution.

3. Système de mesure de décharges partielles conforme à la revendication 2, caractérisé en ce que ledit dispositif d'acquisition de tension (MAT) comprend des moyens (be) conditionnant la fourniture de la mesure de la tension alternative du réseau de distribution par la présence dudit signal de commande d'acquisition (AC).

4. Système de mesure de décharges partielles conforme à la revendication 1 ou 3, caractérisé en ce que l'un desdits deuxième dispositifs d'acquisition (MAT) dit dispositif de déclenchement d'acquisition de tension comprend des moyens (DM1, DM2) sensibles à l'apparition d'une valeur de tension maximale sur l'entrée (ENT) dudit dispositif d'acquisition de tension (MAT) et fournissant alors un signal de commande d'acquisition additionnel (CR).

5. Système de mesure de décharges partielles conforme à l'une des revendications 1, 3, 4, caractérisé en ce que ledit système de mémorisation et de traitement de signaux (ORD) est un calculateur du commerce convenablement programmé.

6. Système de mesure de décharges partielles conforme à la revendication 5, caractérisé en ce que les valeurs de signaux sont converties sous forme numérique, entre le multiplexeur et ledit système de mémorisation et de traitement de signaux.

## Patentansprüche

1. System zur Messung von Teilentladungen, mit ersten (MAD) und zweiten (MAT) Erfassungseinrichtungen, die je einen Signaleingang (EN, ENT) und eine einen Signalwert liefernde Signalformungseinrichtung (DC1, DC2, DM1, DM2) besitzen, und mit einem Multiplexer (MTX), der es ermöglicht, über einen gemeinsamen Kanal nacheinander Signalwerte, die von den verschiedenen Erfassungseinrichtungen geliefert werden, an ein System zu Speicherung und Verarbeitung von Signalen zu liefern, dadurch gekennzeichnet, daß die ersten Erfassungseinrichtungen (MAD) verschiedene Teilentladungssignale empfangen, die von verschiedenen Punkten einer Anlage ausgehen, und daß eine Erfassungsauslöseeinrichtung (LA) vorgesehen ist, die auf das Vorliegen eines von einem Komparator (ce1, ce2) gelieferten Teilentladungssignals (vd1, vd2) anspricht, wenn der Eingangspegel mindestens einer dieser zuletzt erwähnten Erfassungseinrichtungen einen definierten Schwellenwert (V+, V-) überschreitet, und die ein Signal zur Erfassungssteuerung (AC) liefert, wobei das System zur Speicherung und Verarbeitung von Signalen (ORD) auf das Signal zur Erfassungssteuerung anspricht und dann einen Erfassungszyklus durchführt, in dessen Verlauf es über den Multiplexer die von den verschiedenen Erfassungseinrichtung gelieferten Signale speichert.

2. System zur Messung von Teilentladungen nach Anspruch 1, dadurch gekennzeichnet, daß eine der zweiten Erfassungseinrichtungen (MAT), Spannungserfassungseinrichtung genannt, den Augenblickswert der Wechselspannung des Verteilernetzes liefert.

3. System zur Messung von Teilentladungen nach Anspruch 2, dadurch gekennzeichnet, daß die Spannungserfassungseinrichtung (MAT) Mittel (be) aufweist, die die Lieferung des Meßwertes der Wechselspannung des Verteilernetzes vom Vorhandensein des Signals zur Erfassungssteuerung (AC) abhängig machen.

4. System zur Messung von Teilentladungen nach Anspruch 1 oder 3, dadurch gekennzeichnet, daß eine der zweiten Erfassungseinrichtungen (MAT), Spannungserfassungeinrichtung genannt, Mittel (DM1, DM2) aufweist, die auf das Auftreten eines maximalen Spannungswertes am Eingang (ENT) der Spannungserfassungeinrichtung (MAT) ansprechen und dann ein zusätzliches Signal zur Erfassungssteuerung (CR) liefern.

5. System zur Messung von Teilentladungen nach einem der Ansprüche 1, 3, 4, dadurch gekennzeichnet, daß das System zur Speicherung und Verarbeitung von Signalen (ORD) ein passend programmierter, handelsüblicher Rechner ist.

6. System zur Messung von Teilentladungen nach Anspruch 5, dadurch gekennzeichnet, daß die Signalwerte im Schaltungsbereich zwischen dem Multiplexer und dem System zur Speicherung und Verarbeitung von Signalen in Digitalform umgewandelt werden.

## Claims

1. A measurement system for measuring partial discharges comprising first (MAD) and second (MAT) acquisition circuits, each including a signal input (EN, ENT) and a signal shaping circuit (DC1, DC2, DM1, DM2) providing a signal value, a multiplexer (MTX) adapted to deliver signal values provided by the various acquisition circuits, said signal values being delivered in succession on a common path leading to a signal treatment and storage system, the measurement system being characterized in that the first acquisition circuits (MAT) receive different partial discharge signals coming from different points of an installation, and in that an acquisition triggering circuit (LA) is provided responding to the existence of a partial discharge signal (vd1, vd2) provided by a comparator (ce1, ce2) when the input level to at least one of the latter acquisition circuits exceeds a defined threshold (V+, V-) and delivering an acquisition command signal (AC), said signal treatment and storage system (ORD) responding to the acquisition command signal and then performing an acquisition cycle during which it stores the values of the signals provided by the various acquisition circuits via the multiplexer.

2. A measurement system for measuring partial discharges according to claim 1, characterized in that one of said second acquisition circuits (MAT), referred to as a voltage acquisition circuit provides an instantaneous measurement of the alternating voltage of the distribution network.

3. A measurement system for measuring partial discharges according to claim 2, characterized in that the voltage acquisition circuit (MAT) includes means (be) making the supplying of a measurement of the alternating voltage of the distribution network conditional on the presence of said acquisition command signal (AC).

4. A measurement system for measuring partial discharges according to claim 1 or 3, characterized in that one of said second acquisition circuits (MAT), referred to as voltage acquisition trigger circuit includes means (DM1, DM2) sensitive to the appearance of a maximum voltage value on the input (ENT) of said voltage acquisition circuit (MAT) and then providing an additional acquisition command signal (CR).

5. A measurement system for measuring partial discharges according to any one of claims 1, 3, and 4, characterized in that said signal treatment and storage system (ORD) is a suitably programmed commercial computer.

6. A measurement system for measuring partial discharges according to claim 5, characterized in that the values of the signals are converted into digital form between the multiplexer and said signal treatment and storage system.
